# EUROPEAN PATENT APPLICATION

(11) **EP 3 264 516 A1**
(43) Date of publication of application: **03.01.2018**
(21) Application number: 15883283.2
(22) Date of filing: 29.05.2015
(51) Int. Cl.: H01M 10/48, G01R 31/36

(54) **DETERIORATION ASSESSMENT METHOD AND DETERIORATION ASSESSMENT SYSTEM FOR SEALED-TYPE SECONDARY BATTERY**

(30) Priority: 26.02.2015 JP 2015036791
(71) Applicant: TOYO TIRE & RUBBER CO., LTD., Itami-shi Hyogo 664-0847 (JP)
(72) Inventor: FUKUDA, Takeshi, Itami-shi Hyogo 664-0847 (JP); MINAKATA, Nobuyuki, Itami-shi Hyogo 664-0847 (JP)
(74) Representative: Sajda, Wolf E.
(86) International application number: PCT/JP2015/065542
(87) International publication number: WO 2016/135992

(57) **Abstract**

A sealed secondary battery deterioration diagnosis method comprising a step of detecting deformation of the sealed secondary battery (2) and obtaining a first curved line (L1) representing a relationship between a discharged capacity from a fully charged state or a charged capacity up to the fully charged state and a detected deformation amount of the sealed secondary battery (2), a step of obtaining a second curved line (L2) representing a relationship between the charged/discharged capacity and a slope of the first curved line (L1), and a step of determining that the battery is in a deterioration mode brought about by enlargement of reaction distribution when the charged/discharged capacity calculated on the basis of a width of a peak appearing on the second curved line (L2) is larger than the charged/discharged capacity calculated on the basis of a width of a corresponding peak in the predetermined reference state.

## Description

### TECHNICAL FIELD

The present invention relates to a method and a system for diagnosing deterioration of a sealed secondary battery.

### BACKGROUND ART

In recent years, a sealed secondary battery (which may be hereinafter simply referred to as "secondary battery") represented by a lithium ion secondary battery is used as a power source not only for a mobile apparatus such as a portable phone or a notebook personal computer, but also for an electrically driven vehicle such as an electric automobile or a hybrid car. By repetition of charging and discharging, the secondary battery becomes deteriorated, and also it becomes difficult to grasp the residual capacity accurately according as the deterioration proceeds.

Patent Document 1 discloses a method in which a change in the battery voltage per predetermined period of time is successively measured while performing constant-current charging or constant-current discharging of a secondary battery, and a deterioration rate of the secondary battery is calculated on the basis of the period of time during which the change in the battery voltage is below or equal to a predetermined value.

However, such a battery voltage per predetermined period of time changes depending on a charge/discharge history up to the time point of measurement, so that the method is not suitable for use while the charging and discharging are repeated, for example, for use in an environment where the battery is mounted on an electrically driven vehicle in which the charging and discharging are frequently repeated.

Patent Document 2 discloses a method of calculating a charged capacity by fully charging a battery after the battery is once completely discharged, and accumulating the electric current amount of the charging current during that period.

However, in actual use, it is a rare case that the battery is completely discharged, so that the method is not suitable for use while the charging and discharging processes are repeated, for example, for use in an environment where the battery is mounted on an electrically driven vehicle in which the charging and discharging are frequently repeated.

Patent Document 3 discloses a method of detecting the voltage and the internal pressure of a secondary battery and calculating a deterioration of the secondary battery by using a relationship data between the voltage and the internal pressure of a secondary battery that is not yet deteriorated and a relationship data between the internal pressure and the battery capacity of the secondary battery.

However, there are cases in which the deterioration mechanism differs depending on the environment or conditions in which the secondary battery is used, so that relationship data of various patterns must be provided, and moreover, it is difficult to determine which pattern the case corresponds to.

### PRIOR ART DOCUMENTS

### PATENT DOCUMENTS

- Patent Document 1:: JP-A-2002-340997
- Patent Document 2:: JP-A-2008-278624
- Patent Document 3:: JP-A-2013-92398

### SUMMARY OF THE INVENTION

### PROBLEMS TO BE SOLVED BY THE INVENTION

The present invention has been made in view of the aforementioned circumstances, and an object thereof is to provide a method and a system capable of diagnosing deterioration of a sealed secondary battery in a convenient manner and at a high precision even in use while the charging and discharging are repeated.

### MEANS FOR SOLVING THE PROBLEMS

The present invention provides a sealed secondary battery deterioration diagnosis method comprising
- a step of detecting deformation of the sealed secondary battery and obtaining a first curved line representing a relationship between a discharged capacity from a fully charged state or a charged capacity up to the fully charged state and a detected deformation amount of the sealed secondary battery,
- a step of obtaining a second curved line representing a relationship between the charged/discharged capacity and a slope of the first curved line, and
- a step of determining that the battery is in a deterioration mode brought about by enlargement of reaction distribution when the charged/discharged capacity calculated on the basis of a width of a peak appearing on the second curved line is larger than the charged/discharged capacity calculated on the basis of a width of a corresponding peak in the predetermined reference state.

Each of the peaks (summits) appearing on the second curved line is derived from stage change of the electrodes and shows an individual active material amount by which the stage change at that capacity is completed. For this reason, the reaction distribution of the active material in the electrodes can be grasped on the basis of the width of the peak.

By comparison with the reference state, it is possible to determine whether or not the reaction distribution is enlarged, that is, whether or not the battery is in a deterioration mode brought about by enlargement of the reaction distribution. Also, the first curved line from which the second curved line is derived represents the relationship between the discharged capacity from the fully charged state or the charged capacity up to the fully charged state and the deformation amount of the secondary battery.

There are a lot of opportunities in which the battery comes into a fully charged state even in an environment in which charging and discharging are frequently repeated, such as in an electrically driven vehicle. Therefore, by this method, deterioration of a sealed secondary battery can be diagnosed in a convenient manner and at a high precision even in use while the charging and discharging are repeated.

It is preferable to include a step of performing constant-current charging within a range that does not exceed a double of a value obtained by adding a residual capacity at the time of start of charging to the charged capacity at the time of rise of the peak appearing on the second curved line when it is determined that the battery is in the deterioration mode brought about by enlargement of reaction distribution.

This allows that an inconvenience such as generation of deposition of lithium metal can be avoided, and moreover, there is no need to bring the battery into a completely discharged state for that purpose.

In the sealed secondary battery deterioration diagnosis method according to the present invention, it is preferable that a polymer matrix layer is attached to the sealed secondary battery, and the polymer matrix layer contains a filler that is dispersed therein and that changes an external field in accordance with deformation of the polymer matrix layer; and the deformation of the sealed secondary battery is detected by detecting change in the external field accompanying the deformation of the polymer matrix layer.

This allows that deformation of the sealed secondary battery can be detected with a high degree of sensitivity, and deterioration of the sealed secondary battery can be diagnosed with a good precision.

In the above method, it is preferable that the polymer matrix layer contains a magnetic filler as the filler, and the deformation of the sealed secondary battery is detected by detecting change in a magnetic field as the external field. This allows that change in the magnetic field accompanying the deformation of the polymer matrix layer can be wirelessly detected. Also, because a Hall element having a wide sensitivity region can be used, detection with a high degree of sensitivity can be made in a wider range.

The present invention provides a sealed secondary battery deterioration diagnosis system comprising
- a detection sensor for detecting deformation of the sealed secondary battery, and
- a controlling device for obtaining a first curved line representing a relationship between a discharged capacity from a fully charged state or a charged capacity up to the fully charged state and a deformation amount of the sealed secondary battery detected by the detection sensor, obtaining a second curved line representing a relationship between the charged/discharged capacity and a slope of the first curved line, and determining that the battery is in a deterioration mode brought about by enlargement of reaction distribution when the charged/discharged capacity calculated on the basis of a width of a peak appearing on the second curved line is larger than the charged/discharged capacity calculated on the basis of a width of a corresponding peak in the predetermined reference state.

Each of the peaks (summits) appearing on the second curved line is derived from stage change of the electrodes and shows an individual active material amount by which the stage change at that capacity is completed. For this reason, the reaction distribution of the active material in the electrodes can be grasped on the basis of the width of the peak.

By comparison with the reference state, it is possible to determine whether or not the reaction distribution is enlarged, that is, whether or not the battery is in a deterioration mode brought about by enlargement of the reaction distribution. Also, the first curved line from which the second curved line is derived represents the relationship between the discharged capacity from the fully charged state or the charged capacity up to the fully charged state and the deformation amount of the secondary battery.

There are a lot of opportunities in which the battery comes into a fully charged state even in an environment in which charging and discharging are frequently repeated, such as in an electrically driven vehicle. Therefore, by this system, deterioration of a sealed secondary battery can be diagnosed in a convenient manner and at a high precision even in use while the charging and discharging are repeated.

It is preferable that constant-current charging is performed within a range that does not exceed a double of a value obtained by adding a residual capacity at the time of start of charging to the charged capacity at the time of rise of the peak appearing on the second curved line when it is determined that the battery is in the deterioration mode brought about by enlargement of reaction distribution.

This allows that an inconvenience such as generation of deposition of lithium metal can be avoided, and moreover, there is no need to bring the battery into a completely discharged state for that purpose.

In the sealed secondary battery deterioration diagnosis system according to the present invention, it is preferable that the detection sensor comprises a polymer matrix layer attached to the sealed secondary battery and a detection unit; the polymer matrix layer contains a filler that is dispersed therein and that changes an external field in accordance with deformation of the polymer matrix layer; and the detection unit detects change in the external field.

This allows that deformation of the sealed secondary battery can be detected with a high degree of sensitivity, and deterioration of the sealed secondary battery can be diagnosed with a good precision.

In the above system, it is preferable that the polymer matrix layer contains a magnetic filler as the filler, and the detection unit detects change in a magnetic field as the external field. This allows that change in the magnetic field accompanying the deformation of the polymer matrix layer can be wirelessly detected. Also, because a Hall element having a wide sensitivity region can be used, detection with a high degree of sensitivity can be made in a wider range.

### BRIEF DESCRIPTION OF THE DRAWINGS

- FIG. 1: is a block diagram showing one example of a system for executing a deterioration diagnosis method according to the present invention.
- FIG. 2: is a view schematically illustrating a sealed secondary battery, wherein
- FIG. 2A: is a perspective view, and
- FIG. 2B: is an A-A cross-sectional view of the device in Fig. 2A.
- FIG. 3: is a view schematically illustrating a sealed secondary battery, wherein
- FIG. 3A: is a perspective view, and
- FIG. 3B: is a B-B cross-sectional view of the device in Fig. 3A.
- FIG. 4: is a graph showing a relationship between a discharged capacity from a fully charged state and a detected deformation amount of the secondary battery.
- FIG. 5: is a graph showing a relationship between a discharged capacity from a fully charged state and a slope of a first curved line.
- FIG. 6: is a graph showing a relationship between a discharged capacity from a fully charged state and a slope of a first curved line.
- FIG. 7: is a graph showing a relationship between a charged capacity up to the fully charged state and a slope of a first curved line.
- FIG. 8: is a graph showing a relationship between a charged capacity up to the fully charged state and a slope of a first curved line.

### MODES FOR CARRYING OUT THE INVENTION

An embodiment of the present invention will be explained. As will be described later, the deterioration diagnosis method according to the present invention includes a step of obtaining a first curved line, a step of obtaining a second curved line, and a step of determining a deterioration mode brought about by enlargement of a reaction distribution. In the following, a step of calculating a retention rate of an active material and a step of calculating a capacity balance shift amount brought about by side reaction will be further described; however, these steps are optional. The same applies to the deterioration diagnosis system according to the present invention.

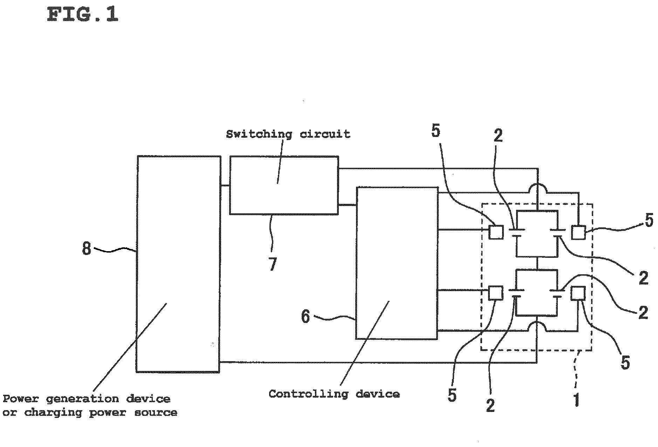

FIG. 1 shows a system that is mounted on an electrically driven vehicle such as an electric automobile or a hybrid car. This system includes a battery module 1 in which an assembled battery constructed with a plurality of sealed secondary batteries 2 is accommodated in a case. In the present embodiment, four secondary batteries 2 are connected in an arrangement of two in parallel by two in series; however, the number of batteries or the connection mode is not limited to this alone. In FIG. 1, only one battery module 1 is shown.

Actually, however, the batteries are mounted as a battery pack including a plurality of battery modules 1. In the battery pack, a plurality of battery modules 1 are connected in series, and the battery modules 1 are accommodated in a case together with various apparatus such as a controller. The case of the battery pack is formed in a shape suitable for mounting on a vehicle, for example, a shape that conforms to the under-floor shape of the vehicle.

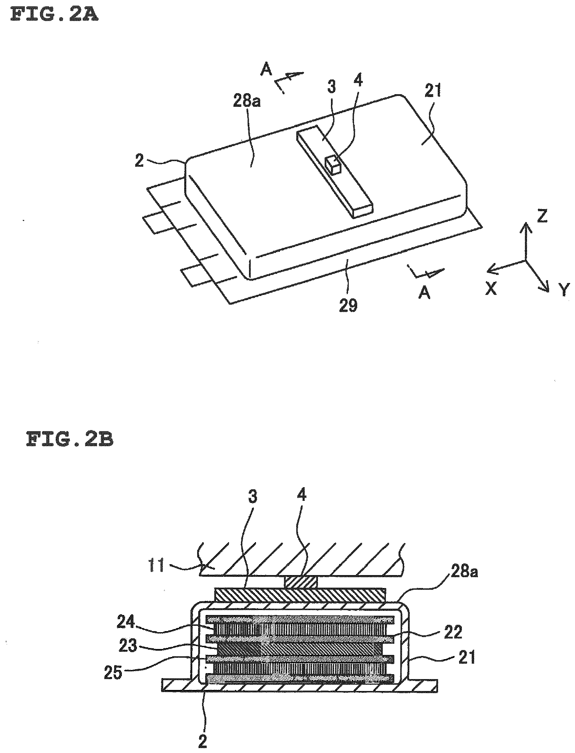

The secondary battery 2 shown in FIG. 2 is constructed as a cell (unit cell) in which an electrode group 22 is accommodated in the inside of a sealed outer casing 21. The electrode group 22 has a structure in which a positive electrode 23 and a negative electrode 24 are stacked or wound via a separator 25 interposed therebetween, and an electrolytic solution is held in the separator 25.

The secondary battery 2 of the present embodiment is a laminate battery using a laminate film such as an aluminum laminate foil as the outer casing 21, and is specifically a laminate-type lithium ion secondary battery having a capacity of 1.44 Ah. The secondary battery 2 is formed to have a thin-type rectangular parallelepiped shape as a whole. The X-, Y-, and Z-directions correspond to the length direction, the width direction, and the thickness direction, respectively, of The secondary battery 2. Also, the Z-direction is the thickness direction of the positive electrode 23 and the negative electrode 24.

A detection sensor 5 that detects deformation of the secondary battery 2 is mounted on the secondary battery 2. The detection sensor 5 includes a polymer matrix layer 3 attached to the secondary battery 2 and a detection unit 4. The polymer matrix layer 3 contains a filler that is dispersed therein and that changes an external field in response to deformation of the polymer matrix layer 3. The polymer matrix layer 3 of the present embodiment is in a sheet form and is formed of an elastomer material that is capable of flexible deformation.

The detection unit 4 detects the change in the external field accompanying the deformation of the polymer matrix layer 3. When the secondary battery 2 swells to be deformed, the polymer matrix layer 3 is deformed in accordance therewith, and change in the external field accompanying the deformation of the polymer matrix layer 3 is detected by the detection unit 4. In this manner, deformation of the secondary battery 1 can be detected with a high degree of sensitivity.

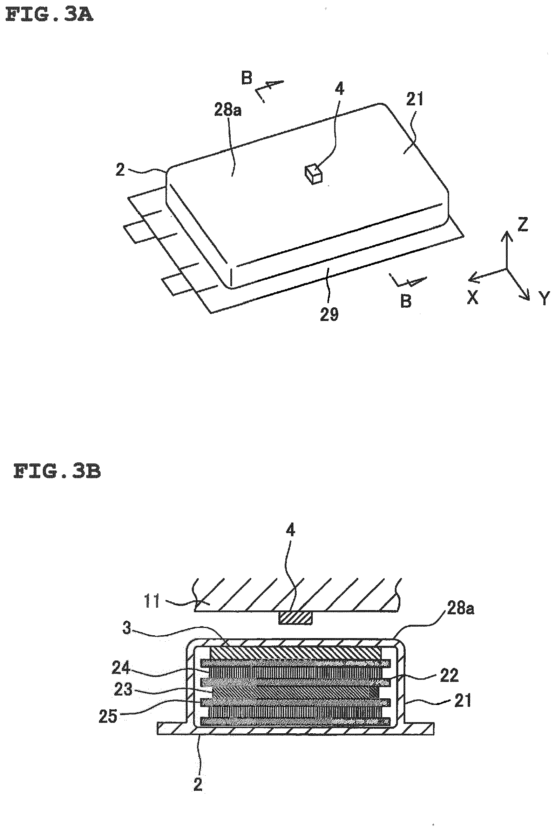

In the example shown in FIG. 2, the polymer matrix layer 3 is attached to the outer casing 21 of the secondary battery 2, so that the polymer matrix layer 3 can be deformed in accordance with the deformation (mainly the swelling) of the outer casing 21. Alternatively, the polymer matrix layer 3 may be attached to the electrode group 22 of the secondary battery 2 as shown in FIG. 3. According to such a construction, the polymer matrix layer 3 can be deformed in accordance with the deformation (mainly the swelling) of the electrode group 22. The deformation of the secondary battery 1 to be detected may be a deformation of either the outer casing 21 or the electrode group 22.

Signals obtained by detection with the detection sensor 5 are transmitted to a controlling device 6, whereby information on the deformation of the secondary battery 2 is supplied to the controlling device 6. The controlling device 6 performs deterioration diagnosis of the secondary battery 2 by using the information, specifically, on the basis of processing including the following steps 1 to 4, more preferably including the steps 5 and 6. In the following example, a behavior of the battery discharged from a fully charged state to an arbitrary discharged state will be described; however, the present invention is not limited to this alone.

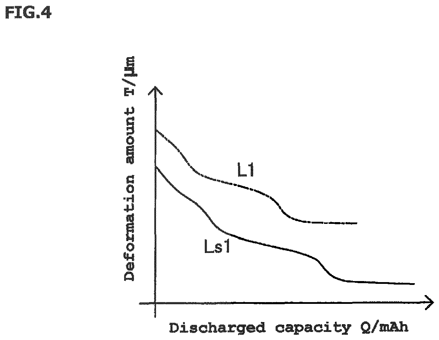

First, deformation of the secondary battery 2 is detected, and a first curved line representing a relationship between a discharged capacity from a fully charged state and a detected deformation amount of the secondary battery 2 is obtained (Step 1). The graph of FIG. 4 shows the first curved line L1 that was obtained in the secondary battery 2 after 500 cycles of a charging/discharging step were repeated. In the charging/discharging step, the secondary battery 2 was put into a thermostat kept at 25 °C and, after being left to stand quietly for 120 minutes, the secondary battery 2 was subjected to constant-current charging up to 4.3 V with a charging current of 1.44 A.

After the voltage had reached 4.3 V, the secondary battery 2 was subjected to constant-voltage charging until the electric current value decayed down to 0.07 A. Thereafter, an open-circuit state was maintained for 10 minutes, and the secondary battery 2 was subjected to constant-current discharging down to 3.0 V with an electric current of 1.44 A. In a secondary battery 2 that had not been used yet and had not been deteriorated, the discharged capacity from the fully charged state thereof to the completely discharged state was 1440 mAh.

In the graph of FIG. 4, the lateral axis represents a discharged capacity Q with the point of origin representing a fully charged state, and the longitudinal axis represents a detected deformation amount T of the secondary battery 2. According as the discharged capacity Q from the fully charged state increases, the deformation amount T of the secondary battery 2 decreases. This is due to the following reason. In the charged secondary battery 2, swelling of the electrode group 22 (which may be hereafter referred to as "electrode swelling") is generated due to change in volume of an active substance.

Accordingly, as the discharging proceeds, the swelling of the electrode group 22 decreases. The curved line Ls1 refers to a secondary battery 2 in a reference state and represents a relationship between a discharged capacity from a fully charged state and a deformation amount of the secondary battery 2. This curved line Ls1 is obtained in the same manner as the first curved line L1 by using a secondary battery 2 that is in an initial stage and is not deteriorated yet as a reference state, for example, by using a secondary battery 2 just after being produced or before being shipped as an object.

In the secondary battery 2, when the electrolytic solution is decomposed due to overcharging or the like, swelling due to rise in the internal pressure caused by the decomposed gas (which may be hereafter referred to as "gas swelling") may be generated. The detection sensor 5 detects deformation of the secondary battery 2 due to this gas swelling as well; however, this is reflected merely as an overall magnitude of the deformation amount T and does not appear as a change accompanying the increase in the discharged capacity Q.

Therefore, in FIG. 4, the fact that the deformation amount T decreases in accordance with increase in the discharged capacity Q is due to the influence of the electrode swelling, while the fact that the first curved line L1 shows a larger deformation amount T than the curved line Ls1 with the same discharged capacity Q is due to the influence of the gas swelling.

The first curved line L1 has a shape including concavity and convexity of some degree, as shown in FIG. 4, due to stage changes of the electrode. For example, in the case of a lithium ion secondary battery using graphite (graphite) in the negative electrode, it is known that the crystal state of the graphite successively undergoes stage change as the discharging proceeds from the fully charged state.

This is because the crystal state of graphite changes stepwise in accordance with the amount of intercalation of lithium ions, and the active substance of the negative electrode expands due to stepwise increase of an average distance between the graphene layers. To sum up, the volume of the active substance changes stepwise by the stage change, and this is reflected on the first curved line L1 and the curved line Ls1. In obtaining the first curved line L1 such as this, the detection sensor 5 that detects deformation of the secondary battery 2 with a high degree of sensitivity is suitable.

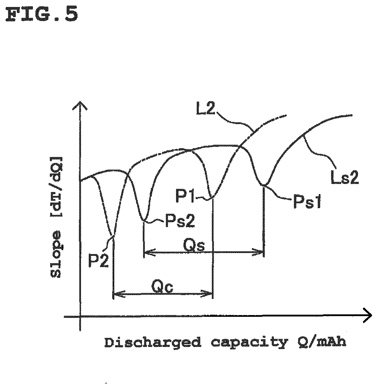

Next, a second curved line is obtained, representing a relationship between the charged/discharged capacity thereof (which is a collective term for discharged capacity and charged capacity and, in the present embodiment, refers to a discharged capacity from the fully charged state) and a slope of the first curved line (Step 2). The graph of FIG. 5 shows the second curved line L2 as obtained from the first curved line L1. This slope dT/dQ of the first curved line L1 is obtained as a differential value when the deformation amount T is differentiated with respect to the discharged capacity Q.

The second curved line L2 has two stage change points P1, P2 that appear as extremal values, and these are due to stage changes described above. The curved line Ls2 represents a relationship between the charged/discharged capacity (discharged capacity in the present embodiment) and a slope of the first curved line with respect to the secondary battery 2 that is in the reference state. This curved line Ls2 can be obtained from the curved line Ls1 according to the same procedure as that in obtaining the second curved line L2 from the first curved line L1. The curved line Ls2 also has two stage change points Ps1, Ps2.

As an active substance for use in the negative electrode of a lithium ion secondary battery, those capable of electrochemically intercalating and deintercalating lithium ions are used. In obtaining the second curved line having a plurality of stage change points such as described above, a negative electrode containing graphite is preferably used. Also, examples of the active substance used in the positive electrode include LiCoO₂, LiMn₂O₄, LiNiO₂, Li(MnAl)₂O₄, Li(NiCoAl)O₂, LiFePO₄, and Li(NiMnCo)O₂.

Subsequently, a charged/discharged capacity Qc between the stage change points appearing as extremal values on the second curved line is calculated (Step 3). The extremal value is a collective term for a local minimal value and a local maximal value, and the stage change points appear as local minimal values during the discharging and appear as local maximal values during the charging. In the present embodiment, the discharged capacity from the fully charged state is observed, so that the stage change points P1, P2 appear as local minimal values. FIG. 5 shows the charged/discharged capacity Qc between the stage change points P1, P2 and the charged/discharged capacity Qs between the stage change points Ps1, Ps2.

For example, in the case of a lithium ion secondary battery in which graphite is used in the negative electrode, the stage change thereof occurs when one or more lithium ions are intercalated with respect to 24 carbons and when one or more lithium ions are intercalated with respect to 12 carbons. Therefore, decrease in the charged/discharged capacity Qc suggests decrease in the amount of carbon capable of intercalating and deintercalating lithium ions such as this. Based on this, deactivation of the active substance can be inferred.

Further, a retention rate of the active substance is calculated on the basis of a ratio Qc/Qs of the charged/discharged capacity Qc relative to the charged/discharged capacity Qs between stage change points in a predetermined reference state (Step 4). For example, when the charged/discharged capacity Qc is 411 mAh and the charged/discharged capacity Qs is 514 mAh, the retention rate R of the active substance can be calculated to be 0.8 (≈ 411/514) on the basis of the ratio Qc/Qs thereof. This means that, in the secondary battery 2 that has been subjected to repetition of the charging and discharging step for 500 cycles, about 80 % of the active substance contributing to the charging and discharging is retained, in other words, the active substance contributing to the charging and discharging has decreased down to be about 80 %. In this manner, deterioration of the secondary battery 2 can be diagnosed.

As described above, the charged/discharged capacity Qc is determined from the second curved line L2, and the first curved line L1 from which the second curved line L2 is derived is obtained as a relationship between the discharged capacity Q from the fully charged state and the deformation amount T of the secondary battery 2. Further, there are a lot of opportunities in which the battery comes into a fully charged state even in an environment in which charging and discharging are frequently repeated, such as in an electrically driven vehicle. Therefore, by the method of the present embodiment, deterioration of the secondary battery 2 can be diagnosed in a convenient manner and at a high precision even in such usage while the charging and discharging are repeated.

The curved line Ls1 is obtained in advance by using a secondary battery 2 that is in an initial stage and is not deteriorated yet as a reference state, for example, by using a secondary battery 2 just after being produced or before being shipped as an object. Therefore, the curved line Ls2, the stage change points Ps1, Ps2, and the charged/discharged capacity Qs can be determined in advance as well. These data can be stored in a storage unit which is provided in the controlling device 6 and not illustrated in the drawings; however, for the above-described deterioration diagnosis, it is sufficient that at least the charged/discharged capacity Qs is known among these.

In the present embodiment, by further executing the following steps 5 and 6, the deterioration of the secondary battery 2 can be diagnosed at a higher precision by calculating a capacity balance shift amount brought about by side reaction. In addition, the capacity balance shift amount brought about by the side reaction, when considered in combination with the retention rate of the active substance, can help to predict the residual capacity of the secondary battery 2.

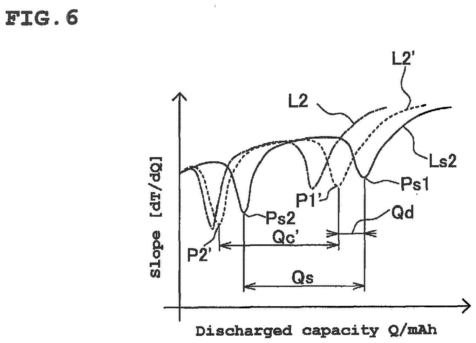

After the charged/discharged capacity Qc is calculated, the second curved line is corrected by using the retention rate of the active substance so that the charged/discharged capacity Qc comes to have the same value as the charged/discharged capacity Qs (Step 5). Specifically, the value of the discharged capacity of the second curved line is divided by the retention rate of the active substance. It is sufficient that this step is carried out after the charged/discharged capacity Qc is calculated, and may be carried out before the retention rate is calculated. The graph of FIG. 6 shows a second curved line L2' obtained by correcting the second curved line L2. When the charged/discharged capacity Qc is 411 mAh and the charged/discharged capacity Qs is 514 mAh, the value of the discharged capacity Q of the second curved line L2 may be divided by 0.8 which is the retention rate R. This allows that the charged/discharged capacity Qc' of the corrected second curved line L2' will be 514 mAh which is the same as the charged/discharged capacity Qs.

The corrected second curved line L2' is obtained as a curved line representing a relationship between the discharged capacity Q from the fully charged state and the slope dT/dQ of the first curved line L1 supposing that there is no deactivation of the active substance grasped by the retention rate R. However, as shown in FIG. 6, the second curved line L2' does not coincide with the curved line Ls2, and a charged/discharged capacity difference Qd is seen between the stage change point P1' (or P2') thereof and the corresponding stage change point Ps1 (or Ps2). This charged/discharged capacity difference Qd is a result of generation of a shift in the capacity balance between the positive electrode 23 and the negative electrode 24, and this shift is generated by the difference between a side reaction amount at the positive electrode 23 and a side reaction amount at the negative electrode 24.

After the second curved line is corrected in the above-described manner, the capacity balance shift amount brought about by side reaction is calculated on the basis of the charged/discharged capacity difference between the stage change point on the corrected second curved line and the corresponding stage change point in a predetermined reference state (Step 6). For example, when the charged/discharged capacity difference Qd is 116 mAh, it can be determined that a superfluous side reaction corresponding to that amount has been generated in the negative electrode 24, and the capacity balance shift amount brought about by the side reaction can be calculated to be an amount corresponding to 116 mAh.

This is considered so because, in order to correct the deactivation amount of the active substance (that is, to make the second curved line L2' coincide with the curved line Ls2), the second curved line L2' must be shifted for an amount of 116 mAh in the positive direction (rightward direction in the graph) of the discharged capacity Q.

In this manner, by not only calculating the retention rate of the active substance but also calculating the capacity balance shift amount brought about by the side reaction, the deterioration of the secondary battery 2 can be diagnosed at a higher precision. Furthermore, by considering this capacity balance shift amount brought about by the side reaction in combination with the retention rate of the active substance, it is possible to infer the end point of the first curved line L1, whereby the residual capacity of the secondary battery 2 can be predicted.

For example, when it is diagnosed that the retention rate R of the active substance is 0.8 and the capacity balance shift amount brought about by the side reaction corresponds to an amount of 116 mAh after 500 cycles of charging and discharging are repeated in a secondary battery in which the capacity before deterioration is 1440 mAh, the value (mAh) of the discharged capacity Q at the end point of the first curved line L1 is inferred from 1440 × 0.8 + 116, and the residual capacity can be predicted by subtracting therefrom the discharged capacity at the time of diagnosis.

As described above, the deterioration diagnosis method and the deterioration diagnosis system of the present embodiment do not simply detect capacity decrease of the secondary battery but can grasp what kind of capacity deterioration is occurring in the secondary battery, and specifically can obtain deterioration information in detail regarding in what ratio the active substance is retained (conversely speaking, in what ratio the active substance has been deactivated) and in what amount the side reaction (electrochemical reaction that does not contribute to charging and discharging) has occurred. Further, the residual capacity can be predicted by inferring the end point of the discharged capacity in the deteriorated secondary battery. The deterioration diagnosis such as this, including the prediction of the residual capacity, is executed by the controlling device 6.

In the above-described embodiment, the behavior when the battery is discharged from the fully charged state to an arbitrary discharged state has been described. Conversely, with respect to a behavior when the battery is charged from an arbitrary discharged state to the fully charged state, deterioration diagnosis can be carried out by the same procedure as described above.

In that case, a first curved line representing a relationship between a charged capacity up to the fully charged state and a detected deformation amount of the secondary battery is obtained in step 1. The lateral axis of the graph of FIG. 4 is reversed and, accordingly, as the charged capacity up to the fully charged state increases (that is, as the battery approaches the fully charged state), the deformation amount of the secondary battery increases.

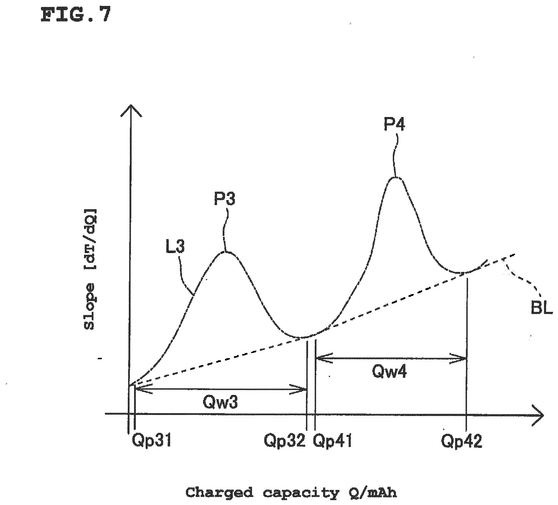

Further, in step 2, a second curved line is obtained, representing a relationship between the charged/discharged capacity thereof (charged capacity up to the fully charged state) and a slope of the first curved line. In the graphs of FIGS. 5 and 6, not only the lateral axis but also the longitudinal axis are reversed, whereby the second curved line having a peak directed upwards is obtained, and stage change points appear as local maximal values on the second curved line (for example, see FIG. 7).

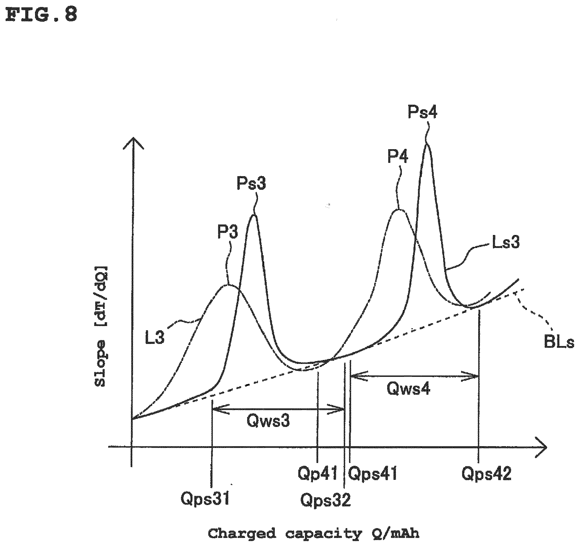

Next, determination of the deterioration mode brought about by enlargement of the reaction distribution will be described with reference to FIGS. 7 and 8. This determination of the deterioration mode can be carried out in combination with the above-described calculation of the retention rate of the active material; however, the determination may be carried out without calculating the retention rate of the active material.

In other words, after the above steps 1 and 2, the process may proceed to a determination step described later without going through the steps 3 and 4. Also, when the calculation of the retention rate of the active material and the determination of the deterioration mode are carried out in combination, either one of these may be carried out first, or alternatively these may be carried out simultaneously.

FIG. 7 is a graph showing a relationship between the charged/discharged capacity (charged capacity up to the fully charged state) and the slope of the first curved line. The second curved line L3 is obtained by steps 1 and 2 such as described above. Depiction of the first curved line from which the second curved line L3 is derived is omitted. The second curved line L3 has two stage change points P3, P4 that appear as extremal values (as local maximal values, because the battery is being charged). Also, on the second curved line L3, there appear two upward-directed peaks having the stage change points P3, P4, and these are due to stage changes described above.

The two peaks that appear on the second curved line L3 each show an amount of individual active substances at the time when the stage change with that capacity (charged capacity in FIG. 7) is completed. The capacity Qp31, Qp41 of the start point of the peak (the point at which the curved line starts to go away from a base line BL) each is a capacity at which the reaction proceeds earliest among the numerous active substances in the electrode, that is, a capacity at which the stage change starts earliest. The capacity Qp32, Qp42 of the end point of the peak (the point at which the curved line starts to be in contact with the base line BL) each is a capacity at which the stage change of all of the active substances in the electrode is completed. The base line BL is obtained by a straight line connecting the inflection points before and after each peak. A charged/discharged capacity Qw3 is calculated on the basis of a base width extending from the start point of the peak to the end point of the peak.

Specifically, the charged/discharged capacity Qw3 is determined by subtracting the capacity Qp31 from the capacity Qp32. A charged/discharged capacity Qw4 is determined in the same manner. The charged/discharged capacity Qw3, Qw4 each shows a distribution of the reaction speed of individual active substances in the electrode. Therefore, by comparing the width of the peak such as the base width before and after deterioration of the secondary battery 2, the reaction distribution of the active substances in the electrode can be grasped.

Generally, enlargement of the reaction distribution is due to increase in the ion resistance or electric resistance within the electrode. By enlargement of the reaction distribution, the charged capacity up to the deposition of lithium metal decreases at the time of charging, whereby lithium metal becomes liable to be deposited. The deposited lithium metal grows in a dendrite form, thereby possibly generating an inconvenience such as provoking a short-circuit between the positive electrode and the negative electrode. Also, at the time of discharging, by enlargement of the reaction distribution, overcharging occurs in the active substance in which the reaction is most liable to proceed, thereby generating an inconvenience of promoting the deterioration of the battery.

The graph in FIG. 8 shows a curved line Ls3 representing a relationship between the charged/discharged capacity (charged capacity in the present embodiment) and the slope of the first curved line in a secondary battery 2 that is in a reference state. In the same manner as the curved line Ls1 in FIG. 4, the first curved line from which the curved line Ls3 is derived can be obtained in advance by using a secondary battery 2 that is in an initial stage and is not deteriorated yet as a reference state, for example, by using a secondary battery 2 just after being produced or before being shipped as an object.

Therefore, not only the curved line Ls3 but also the stage change points Ps3, Ps4, the base line BLs, the capacities Qps31, Qps32, Qps41, Qps42, and the charged/discharged capacities Qws3, Qws4 can be determined in advance as well. The charged/discharged capacity Qws3 is calculated on the basis of a base width of the peak. Specifically, the charged/discharged capacity Qws3 is determined by subtracting the capacity Qps31 from the capacity Qps32. The charged/discharged capacity Qws4 is determined in the same manner.

As described above, the width of each peak reflects the distribution of reaction speed of the active substances in the electrode. Therefore, when the width of the peak appearing on the second curved line L3 is larger than the width of the corresponding peak in a predetermined reference state, it can be determined that the battery is in a deterioration mode due to enlargement of the reaction distribution.

In the present embodiment, as shown in FIGS. 7 and 8, the charged/discharged capacity Qw3 of the second curved line L3 is larger than the corresponding charged/discharged capacity Qws3 in the reference state, so that it is determined that the reaction distribution has enlarged as compared with that before deterioration, that is, the battery is in a deterioration mode due to enlargement of the reaction distribution.

The same applies to a comparison between the charged/discharged capacity Qw4 and the charged/discharged capacity Qws4. In determining the deterioration mode, the comparison may be made with use of either one of the peaks.

In this manner, by comparison between the charged/discharged capacity Qw3 and the charged/discharged capacity Qws3 or by comparison between the charged/discharged capacity Qw4 and the charged/discharged capacity Qws4, enlargement of the reaction distribution can be easily detected. In the present embodiment, the charged/discharged capacities that are compared for determination are calculated on the basis of a base width of the peak.

However, the present invention is not limited to this alone, so that the charged/discharged capacities may be calculated on the basis of another width of the peak. For example, the charged/discharged capacities may be calculated on the basis of a half-value width of the peak (width at a position of half the height of the peak), and determination of the deterioration mode may be made by comparison of these. By such a method as well, enlargement of the reaction distribution before and after the deterioration can be determined.

Further, by obtaining in advance the relationship between the width of the peak and the discharge rate or the capacity for each temperature, the discharge rate of the currently standing battery and the residual capacity dependent on the temperature can also be predicted by making a reference to the results thereof.

Typically, in a lithium ion secondary battery using graphite in the negative electrode, stage changes of a stage 2 and a stage 3 are observed during the charging and discharging. The present embodiment is an example in which graphite is used in the negative electrode. In the graphs of FIGS. 7 and 8, change to the stage 3 is observed as a left peak, and change to the stage 2 is observed as a right peak. Among these, change to the stage 2 is a state in which one lithium ion is intercalated with respect to 12 carbons (carbon atoms).

Deposition of lithium metal that invites various inconveniences occurs in a state in which it is attempted to intercalate two or more lithium ions with respect to 12 carbon atoms (that is, in a state in which it is attempted to intercalate one or more lithium ions with respect to 6 carbon atoms). Therefore, deposition of lithium metal occurs by intercalation of a charged capacity of double or more of the charged capacity from the completely discharged state to the stage 2.

As already described, the charged capacity at the rise of the peak (the charged capacity at the start point) is a capacity at which the reaction proceeds earliest among the numerous active substances in the electrode, that is, a capacity at which the stage change starts earliest in the battery. Therefore, in the peak showing change to the stage 2, the capacity at which lithium metal is deposited can be predicted on the basis of a value of double of the charged capacity at the rise of the peak. From this, it can be determined that, in the present embodiment, the value of double of the charged capacity Qp41 is a capacity at which lithium metal is deposited.

In an initial design of the battery, the battery reaches a set upper-limit voltage before the capacity of double of the charged capacity at the rise of the peak is reached, and operation is switched from the constant-current charging to constant-voltage charging, so that the deposition of lithium metal does not occur. However, as the deterioration of the battery proceeds, the ion resistance or electric resistance increases by sediment onto the active substance surface or loosening of the binding agent, whereby the reaction distribution enlarges, and the charged capacity at the rise of the peak makes a shift towards the lower-capacity side. In that case, it is not possible to avoid the deposition of lithium metal by a controlling method in which the operation is switched to constant-voltage charging after the battery reaches the set upper-limit voltage.

Thus, it is preferable to include a step of performing constant-current charging within a range that does not exceed a double of a value obtained by adding a residual capacity at the time of start of charging to the charged capacity Qp41 at the time of rise of the peak appearing on the second curved line L3 when it is determined that the battery is in the deterioration mode brought about by enlargement of the reaction distribution.

Such a method allows that, even when deterioration brought about by enlargement of the reaction distribution occurs, the constant-current charging is ended by detecting change of the active substance having the highest charging speed to the stage 2, so that deposition of lithium metal does not occur.

As a result of this, safety can be improved, and progress of deterioration can be suppressed. After the constant-current charging is ended, the charging may be ended, or alternatively the operation may be switched to the constant-voltage charging.

In using the battery, it is a rare case that the battery is completely discharged. Typically, charging is started in a state in which some residual capacity is still present. In this case, the charged capacity up to the charged capacity Qp41 changes in accordance with the residual capacity at the time of start of charging. Speaking further, the capacity at which lithium metal is deposited is a charged capacity of double or more of the value obtained by adding the residual capacity at the time of start of charging (which is substantially zero when the battery is in a completely discharged state) to the charged capacity Qp41.

Therefore, in the above step, constant-current charging is performed within a range that does not exceed a double of the value obtained by adding the residual capacity at the time of start of charging to the charged capacity Qp41. For this reason, there is no need to bring the battery into a completely discharged state in making deterioration diagnosis or selecting suitable charging conditions.

In the embodiment shown in FIG. 2, the polymer matrix layer 3 is attached to a wall part 28a of the outer casing 21 that faces the electrode group 22 in the thickness direction of the positive electrode 23 and the negative electrode 24, that is, in the Z-direction (up-and-down direction in FIG. 2B). The outer surface of the wall part 28a corresponds to the upper surface of the outer casing 21. The polymer matrix layer 3 faces the electrode group 22 with the wall part 28a interposed therebetween, and is disposed parallel to the upper surface of the electrode group 22. The electrode swelling is caused by a change in the thickness of the electrode group 22 accompanying the change in volume of the active substance, so that the action in the Z-direction is large. Therefore, in the present embodiment in which the polymer matrix layer 3 is attached to the wall part 28a, the electrode swelling can be detected with a high degree of sensitivity and, as a result, deterioration diagnosis can be made with a good precision.

In the embodiment shown in FIG. 3, the polymer matrix layer 3 is attached in the thickness direction of the positive electrode 23 and the negative electrode 24, that is, in the Z-direction (up-and-down direction in FIG. 3(b)), relative to the electrode group 22. This allows that, even when the outer casing is formed of a robust material such as a metal can, the swelling of the electrode group 22 thereof, that is, the electrode swelling, can be detected with a high degree of precision and, as a result, deterioration diagnosis can be made with a good precision.

The detection unit 4 is disposed at a site where the change in the external field can be detected, and is preferably attached to a comparatively firm site that is hardly affected by the swelling of the secondary battery 2. In the present embodiment, the detection unit 4 is attached to an inner surface of a case 11 of the battery module that faces the wall portion 28a, as shown in FIG. 2B. The case 11 of a battery module is formed, for example, of a metal or a plastic, and there may be cases in which a laminate film is used as the case 11 of the battery module. In the drawings, the detection unit 4 is disposed close to the polymer matrix layer 3; however, the detection unit 4 may be disposed to be distant from the polymer matrix layer 3.

The present embodiment is an example in which the polymer matrix layer 3 contains a magnetic filler as the above-described filler, and the detection unit 4 detects change in a magnetic field as the above-described external field. In this case, the polymer matrix layer 3 is preferably a magnetic elastomer layer in which the magnetic filler is dispersed in a matrix that contains an elastomer component.

The magnetic filler may be, for example, a rare-earth-based, iron-based, cobalt-based, nickel-based, or oxide-based filler; however, a rare-earth-based filler is preferable because a higher magnetic force can be obtained. The shape of the magnetic filler is not particularly limited, so that the shape may be any one of spherical, flattened, needle-like, prismatic, and amorphous shapes. The average particle size of the magnetic filler is preferably from 0.02 µm to 500 µm, more preferably from 0.1 µm to 400 µm, and still more preferably from 0.5 µm to 300 µm.

When the average particle size is smaller than 0.02 µm, the magnetic characteristics of the magnetic filler tend to deteriorate. On the other hand, when the average particle size exceeds 500 µm, the mechanical properties of the magnetic elastomer layer tend to deteriorate, and the magnetic elastomer layer tends to be brittle.

The magnetic filler may be introduced into the elastomer after magnetization; however, it is preferable to magnetize the magnetic filler after introduction into the elastomer. By magnetization after introduction into the elastomer, the polarity of the magnet can be easily controlled, and the magnetic field can be easily detected.

A thermoplastic elastomer, a thermosetting elastomer, or a mixture of these can be used as the elastomer component. Examples of the thermoplastic elastomer include a styrene-based thermoplastic elastomer, a polyolefin-based thermoplastic elastomer, a polyurethane-based thermoplastic elastomer, a polyester-based thermoplastic elastomer, a polyamide-based thermoplastic elastomer, a polybutadiene-based thermoplastic elastomer, a polyisoprene-based thermoplastic elastomer, and a fluororubber-based thermoplastic elastomer.

Also, examples of the thermosetting elastomer include diene-based synthetic rubbers such as polyisoprene rubber, polybutadiene rubber, styrene-butadiene rubber, polychloroprene rubber, nitrile rubber, and ethylene-propylene rubber, non-diene-based synthetic rubbers such as ethylene-propylene rubber, butyl rubber, acrylic rubber, polyurethane rubber, fluororubber, silicone rubber, and epichlorohydrin rubber, and natural rubbers.

Among these, a thermosetting elastomer is preferable, and this is because settling of the magnetic elastomer accompanying the heat generation or overloading of the battery can be suppressed. Further, a polyurethane rubber (which may also be referred to as a polyurethane elastomer) or a silicone rubber (which may also be referred to as a silicone elastomer) is more preferable.

A polyurethane elastomer can be obtained by reacting a polyol with a polyisocyanate. In the case in which the polyurethane elastomer is used as the elastomer component, a magnetic filler is mixed with a compound containing active hydrogen, and further an isocyanate component is added thereto to obtain a mixture liquid. Also, a mixture liquid can also be obtained by mixing a magnetic filler with an isocyanate component, and mixing a compound containing active hydrogen thereto. The magnetic elastomer can be produced by injecting the mixture liquid into a mold that has been subjected to a releasing treatment, and thereafter heating the mixture liquid up to a curing temperature for curing.

Also, in the case in which a silicone elastomer is used as the elastomer component, the magnetic elastomer can be produced by putting a magnetic filler into a precursor of a silicone elastomer, mixing the components, putting the resulting mixture into a mold, and thereafter heating the mixture for curing. A solvent may be added as necessary.

A compound known in the art in the field of polyurethane can be used as the isocyanate component that can be used in the polyurethane elastomer. Examples of the isocyanate component include aromatic diisocyanates such as 2,4-toluene diisocyanate, 2,6-toluene diisocyanate, 2,2'-diphenylmethane diisocyanate, 2,4'-diphenylmethane diisocyanate, 4,4'-diphenylmethane diisocyanate, 1,5-naphthalene diisocyanate, p-phenylene diisocyanate, m-phenylene diisocyanate, p-xylylene diisocyanate, and m-xylylene diisocyanate, aliphatic diisocyanates such as ethylene diisocyanate, 2,2,4-trimethylhexamethylene diisocyanate, and 1,6-hexamethylene diisocyanate, and alicyclic diisocyanates such as 1,4-cyclohexane diisocyanate, 4,4'-dicyclohexylmethane diisocyanate, isophorone diisocyanate, and norbornane diisocyanate. T
hese may be used either alone or as a mixture of two or more kinds. Also, the isocyanate component may be a modified component such as a urethane-modified, allophanate-modified, biuret-modified, or isocyanurate-modified component. Preferable isocyanate components are 2,4-toluene diisocyanate, 2,6-toluene diisocyanate, and 4,4'-diphenylmethane diisocyanate. 2,4-toluene diisocyanate or 2,6-toluene diisocyanate is more preferable.

A compound typically used in the technical field of polyurethane can be used as the compound containing active hydrogen. Examples of the compound containing active hydrogen include high-molecular-weight polyols such as polyether polyols represented by polytetramethylene glycol, polypropylene glycol, polyethylene glycol, and a copolymer of propylene oxide and ethylene oxide, polyester polyols represented by polybutylene adipate, polyethylene adipate, and 3-methyl-1,5-pentane adipate, polyester polycarbonate polyols typified by reaction products of alkylene carbonate and polyester glycol such as polycaprolactone polyol or polycaprolactone, polyester polycarbonate polyols obtained by reacting ethylene carbonate with a polyhydric alcohol and subsequently reacting the obtained reaction mixture with an organic dicarboxylic acid, and polycarbonate polyols obtained by transesterification reaction of a polyhydroxyl compound and aryl carbonate. These may be used either alone or as a mixture of two or more kinds.

In addition to the above-described high-molecular-weight polyol components, low-molecular-weight polyol components such as ethylene glycol, 1,2-propylene glycol, 1,3-propylene glycol, 1,4-butanediol, 1,6-hexanediol, neopentyl glycol, 1,4-cyclohexanedimethanol, 3-methyl-1,5-pentanediol, diethylene glycol, triethylene glycol, 1,4-bis(2-hydroxyethoxy)benzene, trimethylolpropane, glycerin, 1,2,6-hexanetriol, pentaerythritol, tetramethylolcyclohexane, methylglucoside, sorbitol, mannitol, dulcitol, sucrose, 2,2,6,6-tetrakis(hydroxymethyl)cyclohexanol, and triethanolamine, and low-molecular-weight polyamine components such as ethylenediamine, tolylenediamine, diphenylmethanediamine, and diethylenetriamine may be used as the compound containing active hydrogen. These may be used either alone or as a mixture of two or more kinds.

Further, polyamines typified by 4,4'-methylenebis(o-chloroaniline) (MOCA), 2,6-dichloro-p-phenylenediamine, 4,4'-methylenebis(2,3-dichloroaniline), 3,5-bis(methylthio)-2,4-toluenediamine, 3,5-bis(methylthio)-2,6-toluenediamine, 3,5-diethyltoluene-2,4-diamine, 3,5-diethyltoluene-2,6-diamine, trimethyleneglycol-di-p-aminobenzoate, polytetramethyleneoxide-di-p-aminobenzoate, 1,2-bis(2-aminophenylthio)ethane, 4,4'-diamino-3,3'-diethyl-5,5'-dimethyldiphenylmethane, N,N'-di-sec-butyl-4,4'-diaminodiphenylmethane, 4,4'-diamino-3,3'-diethyldiphenylmethane, 4,4'-diamino-3,3'-diethyl-5,5'-dimethyldiphenylmethane, 4,4'-diamino-3,3'-diisopropyl-5,5'-dimethyldiphenylmethane, 4,4'-diamino-3,3',5,5'-tetraethyldiphenylmethane, 4,4'-diamino-3,3',5,5'-tetraisopropyldiphenylmethane, m-xylylenediamine, N,N'-di-sec-butyl-p-phenylenediamine, m-phenylenediamine, and p-xylylenediamine may also be mixed. Preferable compounds containing active hydrogen are polytetramethylene glycol, polypropylene glycol, a copolymer of propylene oxide and ethylene oxide, and 3-methyl-1,5-pentane adipate. More preferable compounds containing active hydrogen are polypropylene glycol and a copolymer of propylene oxide and ethylene oxide.

A preferable combination of the isocyanate component and the compound containing active hydrogen is a combination of one kind or two more kinds of 2,4-toluene diisocyanate, 2,6-toluene diisocyanate, and 4,4'-diphenylmethane diisocyanate as the isocyanate component and one kind or two more kinds of polytetramethylene glycol, polypropylene glycol, a copolymer of propylene oxide and ethylene oxide, and 3-methyl-1,5-pentane adipate as the compound containing active hydrogen. A more preferable combination is a combination of 2,4-toluene diisocyanate and/or 2,6-toluene diisocyanate as the isocyanate component and polypropylene glycol and/or a copolymer of propylene oxide and ethylene oxide as the compound containing active hydrogen.

The polymer matrix layer 3 may be a foamed body containing a dispersed filler and bubbles. A general resin foam can be used as the foamed body. However, in view of the characteristics such as compression set, it is preferable to use a thermosetting resin foam. Examples of the thermosetting resin foam include polyurethane resin foam and silicone resin foam. Among these, polyurethane resin foam is preferable. The isocyanate component and the compound containing active hydrogen that have been listed above can be used for the polyurethane resin foam.

The amount of the magnetic filler in the magnetic elastomer is preferably 1 to 450 parts by weight, more preferably 2 to 400 parts by weight, relative to 100 parts by weight of the elastomer component. When the amount is smaller than 1 part by weight, detection of change in the magnetic field tends to be difficult. When the amount exceeds 450 parts by weight, the magnetic elastomer itself may in some cases become brittle.

For the purpose of preventing rusts of the magnetic filler or the like, a sealing material for sealing the polymer matrix layer 3 may be provided to such a degree that the flexibility of the polymer matrix layer 3 is not deteriorated. A thermoplastic resin, a thermosetting resin, or a mixture of these may be used as the sealing material. The thermoplastic resin may be, for example, styrene-based thermoplastic elastomer, polyolefin-based thermoplastic elastomer, polyurethane-based thermoplastic elastomer, polyester-based thermoplastic elastomer, polyamide-based thermoplastic elastomer, polybutadiene-based thermoplastic elastomer, polyisoprene-based thermoplastic elastomer, fluorine-based thermoplastic elastomer, ethylene·ethyl acrylate copolymer, ethylene·vinyl acetate copolymer, polyvinyl chloride, polyvinylidene chloride, chlorinated polyethylene, fluororesin, polyamide, polyethylene, polypropylene, polyethylene terephthalate, polybutylene terephthalate, polystyrene, polybutadiene, or the like.

The thermosetting resin may be, for example, diene-based synthetic rubbers such as polyisoprene rubber, polybutadiene rubber, styrene·butadiene rubber, polychloroprene rubber, and acrylonitrile·butadiene rubber, non-diene-based rubbers such as ethylene·propylene rubber, ethylene·propylene·diene rubber, butyl rubber, acrylic rubber, polyurethane rubber, fluorine-containing rubber, silicone rubber, and epichlorohydrin rubber, natural rubbers, and thermosetting resins such as polyurethane resin, silicone resin, epoxy resin, or the like. These films may be stacked or may be a film including a metal foil such as aluminum foil or a metal vapor-deposition film including a metal vapor-deposited on the above-described film.

The polymer matrix layer 3 may be one in which the filler is unevenly distributed in the thickness direction thereof. For example, the polymer matrix layer 3 may be made of two layers, that is, a region on a one side containing a relatively larger amount of the filler and a region on the other side containing a relatively smaller amount of the filler. In the region that is located on the one side and that contains a larger amount of the filler, a large change in the external field results from small deformation of the polymer matrix layer 3, so that the sensor sensitivity to a low internal pressure can be enhanced.

Also, a region that is located on the other side and that contains a relatively smaller amount of the filler is comparatively flexible and can be easily moved. Therefore, by attaching this region located on the other side, the polymer matrix layer 3 (particularly the region located on the one side) becomes capable of being easily deformed.

The filler uneven distribution ratio in the region on the one side preferably exceeds 50, and is more preferably 60 or more, still more preferably 70 or more. In this case, the filler uneven distribution ratio in the region on the other side is less than 50. The filler uneven distribution ratio in the region on the one side is 100 at the maximum, and the filler uneven distribution ratio in the region on the other side is 0 at the minimum.

Therefore, it is possible to adopt a stacked body structure including an elastomer layer that contains a filler and an elastomer layer that does not contain the filler. For uneven distribution of the filler, it is possible to use a method in which, after the filler is introduced into the elastomer component, the resultant is left to stand still at room temperature or at a predetermined temperature, so as to attain natural settling of the filler by the weight of the filler.

By changing the temperature or time for leaving the filler to stand still, the filler uneven distribution ratio can be adjusted. The filler may be distributed unevenly by using a physical force such as a centrifugal force or a magnetic force. Alternatively, the polymer matrix layer may be composed of a stacked body made of a plurality of layers having different contents of the filler.

The filler uneven distribution ratio is measured by the following method. That is, the cross-section of the polymer matrix layer is observed at a magnification of 100 times by using a scanning electron microscope - energy dispersive X-ray analyzer (SEM-EDS). The existence amount of the metal element inherent in the filler (for example, Fe element in the magnetic filler of the present embodiment) is determined by element analysis for the whole region in the thickness direction of the cross-section and for each of the two regions obtained by equally dividing the cross-section into two in the thickness direction.

With respect to this existence amount, the ratio of the existence amount in the region on the one side relative to the existence amount in the whole region in the thickness direction is calculated, and this is determined as the filler uneven distribution ratio in the region on the one side. The filler uneven distribution ratio in the region on the other side can be determined in the same manner.

The region on the other side containing a relatively smaller amount of the filler may have a structure formed of a foamed body containing bubbles. This allows that the polymer matrix layer 3 can be more easily deformed, so that the sensor sensitivity is enhanced. Also, the region on the one side as well as the region on the other side may be formed of a foamed body. In this case, the whole of the polymer matrix layer 3 is made of a foamed body. The polymer matrix layer in which at least a part thereof in the thickness direction is made of a foamed body may be composed of a stacked body including a plurality of layers (for example, a non-foamed layer that contains a filler and a foamed layer that does not contain a filler).

As the detection unit 4 for detecting change in the magnetic field, a magnetic resistance element, a Hall element, an inductor, an MI element, a flux gate sensor, or the like can be used, for example. As the magnetic resistance element, a semiconductor compound magnetic resistance element, an anisotropic magnetic resistance element (AMR), a gigantic magnetic resistance element (GMR), and a tunnel magnetic resistance element (TMR) may be mentioned as examples. Among these, a Hall element is preferable, and this is because the Hall element has high sensitivity in a wide range, and is useful as the detection unit 4. As the Hall element, EQ-430L manufactured by Asahi Kasei Microdevices Corporation can be used, for example.

A secondary battery 2 in which gas swelling has proceeded may reach troubles such as ignition or rupture, so that the present embodiment is constructed in such a manner that the charging/discharging is shut off when an expansion amount at the time of deformation of the secondary battery 2 is above or equal to a predetermined level. Specifically, signals obtained by detection with the detection sensor 5 are transmitted to the controlling device 6 and, when a change in the external field above or equal to a set value is detected by the detection sensor 5, the controlling device 6 sends signals to the switching circuit 7 and shuts off the electric current from the power generation device (or charging device) 8, so as to bring the system into a state in which charging/discharging of the battery module 1 is shut off. This allows that the troubles caused by gas swelling can be prevented.

In the above-described embodiment, an example in which the secondary battery is a lithium ion secondary battery has been shown; however, the present invention is not limited to this alone. The secondary battery that is put to use is not limited to a non-aqueous electrolyte secondary battery such as a lithium ion battery, but may be an aqueous electrolyte secondary battery such as a nickel hydrogen battery.

In the embodiments, an example has been shown in which change in the magnetic field accompanying the deformation of the polymer matrix layer is detected with the detection unit; however, it is possible to adopt a construction in which change in another external field is detected. For example, a construction may be considered in which the polymer matrix layer contains an electroconductive filler such as metal particles, carbon black, or carbon nanotubes as the filler, and the detection unit detects change in the electric field (change in the resistance and the dielectric constant) as the external field.

The present invention is not limited to the embodiments specified in detail above, but can be improved and modified variously within the scope of the present invention.

### DESCRIPTION OF REFERENCE SIGNS

- 1: Battery module
- 2: Sealed secondary battery
- 3: Polymer matrix layer
- 4: Detection unit
- 5: Detection sensor
- 6: Controlling device
- 7: Switching circuit
- 8: Power generation device or charging device
- 21: Outer casing
- 22: Electrode group
- 23: Positive electrode
- 24: Negative electrode
- 25: Separator
- L1: First curved line
- L2: Second curved line
- P1: Stage change point
- P2: Stage change point

## Claims

1. A sealed secondary battery deterioration diagnosis method, comprising:
- a step of detecting deformation of the sealed secondary battery and obtaining a first curved line representing a relationship between a discharged capacity from a fully charged state or a charged capacity up to the fully charged state and a detected deformation amount of the sealed secondary battery;
- a step of obtaining a second curved line representing a relationship between the charged/discharged capacity and a slope of the first curved line; and
- a step of determining that the battery is in a deterioration mode brought about by enlargement of reaction distribution when the charged/discharged capacity calculated on the basis of a width of a peak appearing on the second curved line is larger than the charged/discharged capacity calculated on the basis of a width of a corresponding peak in the predetermined reference state.

2. The sealed secondary battery deterioration diagnosis method
according to claim 1,
comprising a step of performing constant-current charging within a range that does not exceed a double of a value obtained by adding a residual capacity at the time of start of charging to the charged capacity at the time of rise of the peak appearing on the second curved line when it is determined that the battery is in the deterioration mode brought about by enlargement of reaction distribution.

3. The sealed secondary battery deterioration diagnosis method
according to claim 1 or 2,
wherein a polymer matrix layer is attached to the sealed secondary battery, and the polymer matrix layer contains a filler that is dispersed therein and that changes an external field in accordance with deformation of the polymer matrix layer; and
wherein the deformation of the sealed secondary battery is detected by detecting a change in the external field accompanying the deformation of the polymer matrix layer.

4. The sealed secondary battery deterioration diagnosis method
according to claim 3,
wherein the polymer matrix layer contains a magnetic filler as the filler, and
wherein the deformation of the sealed secondary battery is detected by detecting a change in a magnetic field as the external field.

5. A sealed secondary battery deterioration diagnosis system comprising:
- a detection sensor for detecting deformation of the sealed secondary battery; and
- a controlling device for obtaining a first curved line representing a relationship between a discharged capacity from a fully charged state or a charged capacity up to the fully charged state and a deformation amount of the sealed secondary battery detected by the detection sensor, obtaining a second curved line representing a relationship between the charged/discharged capacity and a slope of the first curved line, and determining that the battery is in a deterioration mode brought about by enlargement of reaction distribution when the charged/discharged capacity calculated on the basis of a width of a peak appearing on the second curved line is larger than the charged/discharged capacity calculated on the basis of a width of a corresponding peak in the predetermined reference state.

6. The sealed secondary battery deterioration diagnosis system
according to claim 5,
wherein constant-current charging is performed within a range that does not exceed a double of a value obtained by adding a residual capacity at the time of start of charging to the charged capacity at the time of rise of the peak appearing on the second curved line when it is determined that the battery is in the deterioration mode brought about by enlargement of reaction distribution.

7. The sealed secondary battery deterioration diagnosis system
according to claim 5 or 6,
wherein the detection sensor comprises a polymer matrix layer attached to the sealed secondary battery and a detection unit;
wherein the polymer matrix layer contains a filler that is dispersed therein and that changes an external field in accordance with deformation of the polymer matrix layer; and
wherein the detection unit is adapted to detect a change in the external field.

8. The sealed secondary battery deterioration diagnosis system
according to claim 7,
wherein the polymer matrix layer contains a magnetic filler as the filler, and the detection unit is adapted to detect change in a magnetic field as the external field.
